(19) Europäisches Patentamt
European Patent Office
Office européen des brevets

(11) **EP 3 147 677 B1**

(12) **EUROPÄISCHE PATENTSCHRIFT**

(45) Veröffentlichungstag und Bekanntmachung des Hinweises auf die Patenterteilung:
**16.06.2021   Patentblatt 2021/24**

(21) Anmeldenummer: **16184175.4**

(22) Anmeldetag: **15.08.2016**

(51) Int Cl.:
*G01R 19/06* *(2006.01)*   *G01R 19/165* *(2006.01)*
*G01R 15/18* *(2006.01)*   *G01R 19/25* *(2006.01)*
*G01R 23/16* *(2006.01)*

(54) **STROMMESSVORRICHTUNG**

CURRENT MEASURING DEVICE

DISPOSITIF DE MESURE DE COURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.09.2015   DE 102015116084**

(43) Veröffentlichungstag der Anmeldung:
**29.03.2017   Patentblatt 2017/13**

(73) Patentinhaber: **Hochschule Konstanz**
**78462 Konstanz (DE)**

(72) Erfinder: **Prof. Dr. Fromm, Wilhelm**
**8280 Kreuzlingen (CH)**

(74) Vertreter: **Daub, Thomas**
**Patent- und Rechtsanwaltskanzlei Daub**
**Bahnhofstrasse 5**
**88662 Überlingen (DE)**

(56) Entgegenhaltungen:
CN-A- 103 529 321       GB-A- 2 432 008
JP-A- H09 145 759       US-A- 4 274 052
US-A1- 2006 203 412

• RICH HUNT: "Impact of CT Errors on Protective Relays Case Studies and Analyses", IEEE TRANSACTIONS ON INDUSTRY APPLICATIONS, IEEE SERVICE CENTER, PISCATAWAY, NJ, US, Bd. 48, Nr. 1, 1. Januar 2012 (2012-01-01), Seiten 52-61, XP011397702, ISSN: 0093-9994, DOI: 10.1109/TIA.2011.2175879

EP 3 147 677 B1

## Beschreibung

## Stand der Technik

Die Erfindung betrifft eine Strommessvorrichtung nach dem Oberbegriff des Anspruchs 1 sowie ein Verfahren nach dem Oberbegriff des Anspruchs 10.

Es sind bereits Strommessvorrichtungen zur Messung von Wechselströmen vorgeschlagen worden, welche mittels eines induktiven Stromwandlers einen Primärstrom in einen Sekundärstrom umwandeln und diesen auswerten. Insbesondere eine Sättigung des Stromwandlers kann zu einer Verfälschung des Sekundärstroms und somit zu einer fehlerhaften Messung des Primärstroms führen.

Aus der JP H09 145759 A ist bereits eine Strommessvorrichtung zur Messung eines Leckstroms eines Überspannungsableiters bekannt. Die Strommessvorrichtung umfasst eine als Rogowski-Spule ausgebildete induktive Koppeleinheit, welche dazu vorgesehen ist, zumindest ein elektrisches Primärsignal in zumindest ein elektrisches Sekundärsignal zu wandeln, und eine Recheneinheit, welche zu einer Charakterisierung des Primärsignals aus dem Sekundärsignal vorgesehen ist, wobei die Recheneinheit dazu vorgesehen ist, zumindest eine höhere Harmonische des Sekundärsignals bei der Charakterisierung des Primärsignals zu berücksichtigen.

Die Aufgabe der Erfindung besteht insbesondere darin, eine gattungsgemäße Strommessvorrichtung mit vorteilhaften Eigenschaften hinsichtlich einer Messung eines Wechselstroms bereitzustellen. Die Aufgabe wird erfindungsgemäß durch die Merkmale des Patentanspruchs 1 gelöst, während vorteilhafte Ausgestaltungen und Weiterbildungen der Erfindung den Unteransprüchen entnommen werden können.

## Vorteile der Erfindung

Die Erfindung geht aus von einer Strommessvorrichtung zur Messung zumindest eines Wechselstroms mit zumindest einer induktiven Koppeleinheit, welche dazu vorgesehen ist, zumindest ein elektrisches Primärsignal in zumindest ein elektrisches Sekundärsignal zu wandeln, und mit einer Recheneinheit, welche zu einer Bestimmung des Primärsignals aus dem Sekundärsignal vorgesehen ist.

Es wird vorgeschlagen, dass die Recheneinheit dazu vorgesehen ist, zumindest eine höhere Harmonische des Sekundärsignals, insbesondere zusätzlich zu einer Grundschwingung des Sekundärsignals, bei der Bestimmung des Primärsignals zu berücksichtigen.

Unter einer "Strommessvorrichtung" soll in diesem Zusammenhang insbesondere zumindest ein Teil, insbesondere eine Unterbaugruppe, eines insbesondere elektronischen Mess-, Schutz-, Überwachungs- und/oder Steuerungsgeräts verstanden werden. Insbesondere kann die Strommessvorrichtung teilweise oder vollständig in ein Mess-, Schutz-, Überwachungs- und/oder Steuerungsgerät integriert sein und/oder über zumindest eine Mess- und/oder Datenleitung mit einem Mess-, Schutz-, Überwachungs- und/oder Steuerungsgerät gekoppelt sein. Unter einem "Wechselstrom" soll in diesem Zusammenhang insbesondere ein sinusförmiger Wechselstrom mit einer zumindest im Wesentlichen gleichbleibenden, insbesondere zumindest annähernd bekannten, Frequenz verstanden werden. Insbesondere entspricht eine Frequenz des Wechselstroms zumindest im Wesentlichen einer Netzfrequenz eines Energieversorgungsnetzes. Unter einer "induktiven Koppeleinheit" soll insbesondere eine Einheit verstanden werden, welche zumindest einen Signaleingang und zumindest einen Signalausgang aufweist, welche induktiv miteinander gekoppelt sind. Die induktive Koppeleinheit weist zumindest eine Primärwicklung und zumindest eine Sekundärwicklung auf, welche auf einen gemeinsamen ferromagnetischen Kern, insbesondere über einen Eisenkern und/oder einen Ferritkern, gewickelt sind, welcher die Primärwicklung mit der Sekundärwicklung koppelt. Die Primärwicklung bildet insbesondere den Signaleingang, während die Sekundärwicklung insbesondere den Signalausgang der induktiven Koppeleinheit bildet. Insbesondere ist die induktive Koppeleinheit als ein Messwandler, vorzugsweise als ein Stromwandler, ausgebildet. Unter einem "elektrischen Primärsignal" soll in diesem Zusammenhang insbesondere ein Stromsignal verstanden werden, welches zumindest einen Wechselanteil aufweist. Vorzugsweise ist das Primärsignal ein insbesondere rein sinusförmiges Wechselstromsignal. Insbesondere ist das Primärsignal dazu vorgesehen, eingangsseitig in die Koppeleinheit eingespeist zu werden. Unter einem "elektrischen Sekundärsignal" soll in diesem Zusammenhang insbesondere ein zu dem Primärsignal gehöriges Strom- und/oder Spannungssignal verstanden werden, welches zumindest einen Wechselanteil, insbesondere einen Wechselstromanteil und/oder einen Wechselspannungsanteil, aufweist. Insbesondere ist das Sekundärsignal dazu vorgesehen, ausgangsseitig an der Koppeleinheit abgegriffen zu werden. Unter einer "Recheneinheit" soll insbesondere ein Controller mit einem Prozessor, einer Speichereinheit, und/oder ein in der Speichereinheit gespeichertes Betriebs-, Steuer- und/oder Berechnungsprogramm verstanden werden. Insbesondere ist zumindest ein Signal- und/oder Dateneingang der Recheneinheit mit zumindest einem Signalausgang der induktiven Koppeleinheit verbunden.

Unter einer "höheren Harmonischen des Sekundärsignals" soll insbesondere eine sinusförmige harmonische Schwingungen verstanden werden, deren Frequenz einem ganzzahligen Vielfachen einer Grundfrequenz des Sekundärsignals entspricht. Darunter, dass die Recheneinheit dazu vorgesehen ist, zumindest eine höhere Harmonische des Sekundärsignals bei der Bestimmung des Primärsignals "zu berücksichtigen", soll insbesondere verstanden werden, dass die Recheneinheit dazu vorgesehen ist, zumindest eine höhere Harmonische des Sekundärsignals kontinuierlich oder quasikontinuierlich, beispielsweise mittels einer harmonischen Analyse, insbesondere einer Fourier-Analyse, beispielsweise unter Verwendung einer diskreten und/oder schnellen Fourier-Transformation, zu erfassen und/oder zu berechnen und unter Verwendung der zumindest einen höheren Harmonischen des Sekundärsignals kontinuierlich und/oder quasikontinuierlich das Primärsignal zu berechnen und/oder zu bestimmen.

Durch eine derartige Ausgestaltung kann eine gattungsgemäße Strommessvorrichtung mit vorteilhaften Eigenschaften hinsichtlich einer Messung von Amplitude und Phasenwinkel eines Wechselstroms bereitgestellt werden. Insbesondere kann durch eine Berücksichtigung zumindest einer höheren Harmonischen des Sekundärsignals vorteilhaft zuverlässig ein Primärsignal bestimmt werden. Insbesondere kann ein Primärsignal aus dem Sekundärsignal ohne Berücksichtigung weiteren Parameter, insbesondere von Parametern der induktiven Koppeleinheit, bestimmt werden. Ferner kann auch bei einer Sättigung eines Kerns der induktiven Koppeleinheit, welche zu einer Verfälschung des Sekundärsignals führt, ein Primärsignal vorteilhaft exakt aus dem Sekundärsignal bestimmt werden.

Ferner wird vorgeschlagen, dass die Recheneinheit dazu vorgesehen ist, eine Amplitude der höheren Harmonischen zu berücksichtigen. Unter einer "Amplitude" soll insbesondere eine maximale Auslenkung einer sinusförmigen Wechselgröße aus der Lage des arithmetischen Mittelwerts verstanden werden. Des Weiteren wird vorgeschlagen, dass die Recheneinheit dazu vorgesehen ist, einen Phasenwinkel der höheren Harmonischen zu berücksichtigen. Vorzugsweise ist die Recheneinheit dazu vorgesehen, sowohl die Amplitude als auch den Phasenwinkel der höheren Harmonischen zu berücksichtigen. Hierdurch kann/können auf vorteilhaft einfache Weise eine Amplitude und/oder ein Phasenwinkel eines Primärsignals aus einem Sekundärsignal bestimmt werden.

Ferner wird vorgeschlagen, dass die höhere Harmonische eine ungeradzahlige höhere Harmonische des Sekundärsignals ist. Vorzugsweise ist die höhere Harmonische die dritte Harmonische des Sekundärsignals. Insbesondere ungeradzahlige höhere Harmonische und besonders die dritte Harmonische des Sekundärsignals sind/ist charakteristisch für ein Maß einer Sättigung eines Kerns der induktiven Koppeleinheit bei sinusförmigen Wechselströmen. Hierdurch kann selbst bei einer Sättigung eines Kerns ein Primärsignal aus einem Sekundärsignal vorteilhaft exakt bestimmt werden.

Die Recheneinheit ist dazu vorgesehen, anhand der höheren Harmonischen, insbesondere anhand einer ungeradzahligen höheren Harmonischen und vorzugsweise anhand der dritten Harmonischen, einen Korrekturwert zur Bestimmung des Primärsignals aus der Grundschwingung des Sekundärsignals zu ermitteln. Unter einem "Korrekturwert" soll insbesondere ein Wert verstanden werden, welcher dazu vorgesehen ist, zur Bestimmung des Primärsignals mit dem Sekundärsignal verrechnet zu werden. Hierdurch kann vorteilhaft einfach auch aus einem verfälschten Sekundärsignal das korrekte Primärsignal bestimmt werden.

In einer bevorzugten Ausgestaltung der Erfindung wird vorgeschlagen, dass die Recheneinheit dazu vorgesehen ist, den Korrekturwert anhand eines insbesondere betragsmäßigen Verhältnisses der höheren Harmonischen, insbesondere einer ungeradzahligen höheren Harmonischen und vorzugsweise der dritten Harmonischen, zu der Grundschwingung des Sekundärsignals zu ermitteln. Insbesondere kann das Verhältnis der höheren Harmonischen zu der Grundschwingung durch eine Division des komplexen Zeigers der höheren Harmonischen mit Real- und Imaginärteil durch den komplexen Zeiger der Grundschwingung mit Real- und Imaginärteil erfolgen. Hierdurch kann auf vorteilhaft einfache und/oder schnelle Weise der Korrekturwert ermittelt werden.

Des Weiteren wird eine Wechselspannungsanlage mit zumindest einer Strommessvorrichtung vorgeschlagen. Unter einer "Wechselspannungsanlage" soll in diesem Zusammenhang insbesondere eine Anlage mit zumindest einer Wechselspannungsquelle und zumindest einer Wechselspannungssenke verstanden werden. Insbesondere kann die Wechselspannungssenke als ein wechselspannungsbetriebendes Gerät und/oder eine wechselspannungsbetriebende Maschine ausgebildet sein. Insbesondere ist die Wechselspannungssenke über zumindest eine Versorgungsleitung mit der Wechselspannungsquelle verbunden. Insbesondere ist die Strommessvorrichtung dazu vorgesehen, einen Wechselstrom innerhalb der zumindest einen Versorgungsleitung zu messen. Hierdurch kann vorteilhaft ein Wechselstrom in einer Versorgungsleitung einer Wechselspannungsanlage gemessen werden. Insbesondere können auch Wechselströme bei größeren Abweichungen einer Stromgröße von den Bemessungswerten mit Sättigung des Stromwandlers, beispielsweise aufgrund eines Kurzschlusses, vorteilhaft detektiert werden.

Zudem wird ein Verfahren vorgeschlagen mit einer Strommessvorrichtung zur Messung zumindest eines Wechselstroms mit zumindest einer induktiven Koppeleinheit, welche dazu vorgesehen ist, zumindest ein elektrisches Primärsignal in zumindest ein elektrisches Sekundärsignal zu wandeln, und mit einer Recheneinheit, welche zu einer Bestimmung des Primärsignals aus dem Sekundärsignal vorgesehen ist, wobei bei der Bestimmung des Primärsignals, insbesondere zusätzlich zu der Grundschwingung des Sekundärsignals, zumindest eine höhere Harmonische des Sekundärsignals berücksichtigt wird. Durch eine Berücksichtigung zumindest einer höheren Harmonischen des Sekundärsignals kann vorteilhaft zuverlässig das Primärsignal mit Betrag und Winkel seiner Grundschwingung bestimmt werden. Insbesondere kann das Primärsignal aus dem Sekundärsignal ohne Berücksichtigung weiterer Parameter, insbesondere von Parametern der induktiven Koppeleinheit, bestimmt werden. Ferner kann auch bei einer Sättigung eines Kerns der induktiven Koppeleinheit, welche zu einer Verfälschung des Sekundärsignals führt, ein Primärsignal vorteilhaft exakt aus dem Sekundärsignal bestimmt werden.

Die erfindungsgemäße Strommessvorrichtung soll hierbei nicht auf die oben beschriebene Anwendung und Ausführungsform beschränkt sein. Insbesondere kann die erfindungsgemäße Strommessvorrichtung zu einer Erfüllung einer hierin beschriebenen Funktionsweise eine von einer hierin genannten Anzahl von einzelnen Elementen, Bauteilen und Einheiten abweichende Anzahl aufweisen.

**Zeichnungen**

Weitere Vorteile ergeben sich aus der folgenden Zeichnungsbeschreibung. In den Zeichnungen ist ein Ausführungsbeispiel der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:

Fig. 1 eine Wechselspannungsanlage mit einer Strommessvorrichtung, welche eine induktive Koppeleinheit und eine Recheneinheit aufweist,

Fig. 2 einen zeitlichen Verlauf eines Primärsignals und eines Sekundärsignals,

Fig. 3 einen zeitlichen Verlauf eines Primärsignals und eines Sekundärsignals bei Sättigung der induktiven Koppeleinheit,

Fig. 4 die Grundschwingung und die dritte Harmonische des Sekundärsignals in Abhängigkeit von einer relativen Sättigung der induktiven Koppeleinheit und

Fig. 5 einen Korrekturwert in Abhängigkeit von einem Verhältnis der dritten Harmonischen zu der Grundschwingung des Sekundärsignals.

**Beschreibung des Ausführungsbeispiels**

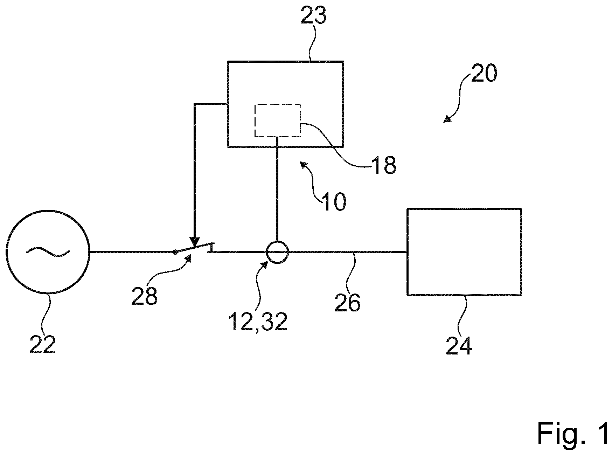

Figur 1 zeigt eine Wechselspannungsanlage 20 mit einer Wechselspannungsquelle 22 und einer Wechselspannungssenke 24. Die Wechselspannungssenke 24 ist über eine Versorgungsleitung 26 mit der Wechselspannungsquelle 22 verbunden. In der Versorgungsleitung 26 ist ein Schalter 28 angeordnet, welcher dazu vorgesehen ist, eine Stromversorgung der Wechselspannungssenke 24 herzustellen und/oder zu trennen. Die Wechselspannungsanlage 20 umfasst eine Strommessvorrichtung 10 zur Messung zumindest eines Wechselstroms. Insbesondere ist die Strommessvorrichtung 10 zur Messung eines Wechselstroms innerhalb der Versorgungsleitung 26 vorgesehen. Die Strommessvorrichtung 10 ist hier beispielhaft in ein Schutzgerät 30 integriert. Das Schutzgerät 30 ist insbesondere dazu vorgesehen, die Stromversorgung der Wechselspannungssenke 24 bei Feststellung eines Überstroms durch Öffnen des Schalters 28 zu unterbrechen. Alternativ kann eine Strommessvorrichtung beispielsweise auch in ein Überwachungsgerät und/oder ein Steuergerät integriert sein.

Die Strommessvorrichtung 10 weist eine induktive Koppeleinheit 12 auf. Die induktive Koppeleinheit 12 ist als ein induktiver Stromwandler 32 ausgebildet. Die induktive Koppeleinheit 12 ist dazu vorgesehen, ein elektrisches Primärsignal 14 in ein elektrisches Sekundärsignal 16 zu wandeln. Das Primärsignal 14 ist ein sinusförmiges Wechselstromsignal und entspricht einem Wechselstrom in der Versorgungsleitung 26. Ferner weist die Strommessvorrichtung 10 eine Recheneinheit 18 auf, welche zu einer Bestimmung des Primärsignals 14 aus dem Sekundärsignal 16 vorgesehen ist. Die Recheneinheit 18 ist derart mit der induktiven Koppeleinheit 12 verbunden, dass der Recheneinheit 18 das Sekundärsignal 16 zu einer Weiterverarbeitung zugeführt wird.

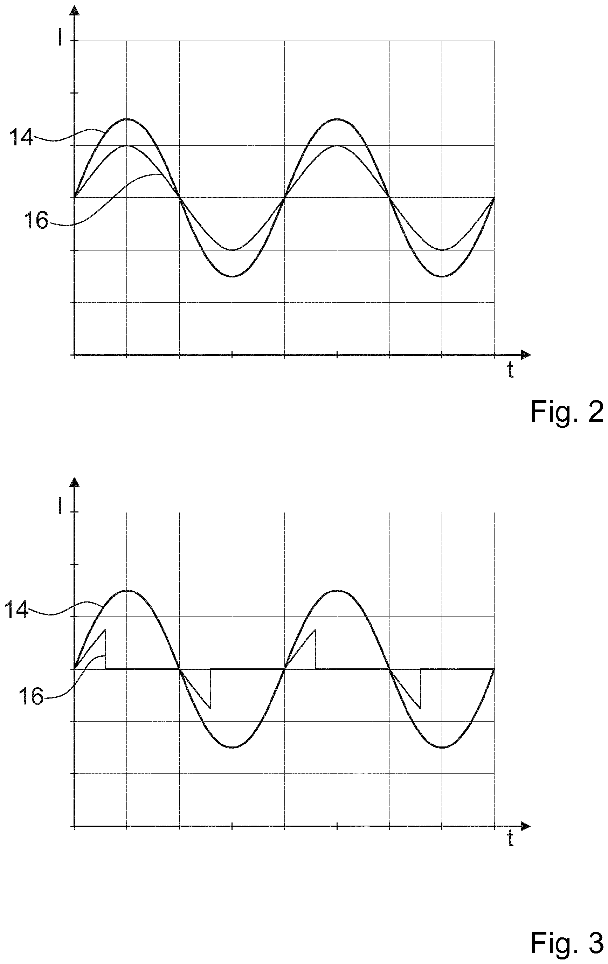

Figur 2 zeigt einen beispielhaften zeitlichen Verlauf eines Primärsignals 14 und eines Sekundärsignals 16. Sowohl das Primärsignal 14 als auch das Sekundärsignal 16 weisen einen sinusförmigen Verlauf auf. Das Sekundärsignal 16 weist aufgrund eines Übersetzungsverhältnisses der induktiven Koppeleinheit 12 gegenüber dem Primärsignal 14 eine geringere Amplitude auf. Bei dem in der Figur 2 gezeigten Fall kann bei bekanntem Übersetzungsverhältnis von dem Sekundärsignal 16 unmittelbar auf das Primärsignal 14 geschlossen werden. Figur 3 zeigt einen weiteren beispielhaften zeitlichen Verlauf eines Primärsignals 14 und eines Sekundärsignals 16 bei einer Sättigung der induktiven Koppeleinheit 12. Während das Primärsignal 14 einen sinusförmigen Verlauf aufweist, zeigt sich, dass das Sekundärsignal 16 betragsmäßig zu klein ist, und aufgrund der vorverschobenen Nulldurchgänge mit einer voreilenden Phasenlage erfasst wird. Bei dem in der Figur 3 gezeigten Fall kann bei lediglicher Kenntnis des Übersetzungsverhältnisses nicht unmittelbar von einem Sekundärsignal 16 auf das Primärsignal 14 geschlossen werden.

Die Recheneinheit 18 ist dazu vorgesehen, zumindest eine höhere Harmonische des Sekundärsignals 16 bei der Bestimmung des Primärsignals 14 zu berücksichtigen. Die Recheneinheit 18 ist dazu vorgesehen, eine Amplitude und einen Phasenwinkel der höheren Harmonischen zu berücksichtigen. Die höhere Harmonische ist eine höhere Harmonische niedriger Ordnung des Sekundärsignals 16, für Signale ohne Gleichanteil vorzugsweise die dritte Harmonische des Sekundärsignals 16. Die Auswertung der höheren Harmonischen des Sekundärsignals 16 kann beispielsweise entsprechend einer Fourier-Analyse mittels Fourierfilterung erfolgen.

Die Recheneinheit 18 ist dazu vorgesehen, anhand der höheren Harmonischen einen Korrekturwert k zur Bestimmung des Primärsignals 14 zu ermitteln. Mit den komplexen Zeigern für das Primärsignal 14 ($\underline{I}_p$) und das Sekundärsignal 16 ($\underline{I}_s$) und dem Korrekturwert k ergibt sich folgender Ansatz:

$$\underline{I}_s = \underline{k} \times \underline{I}_p$$

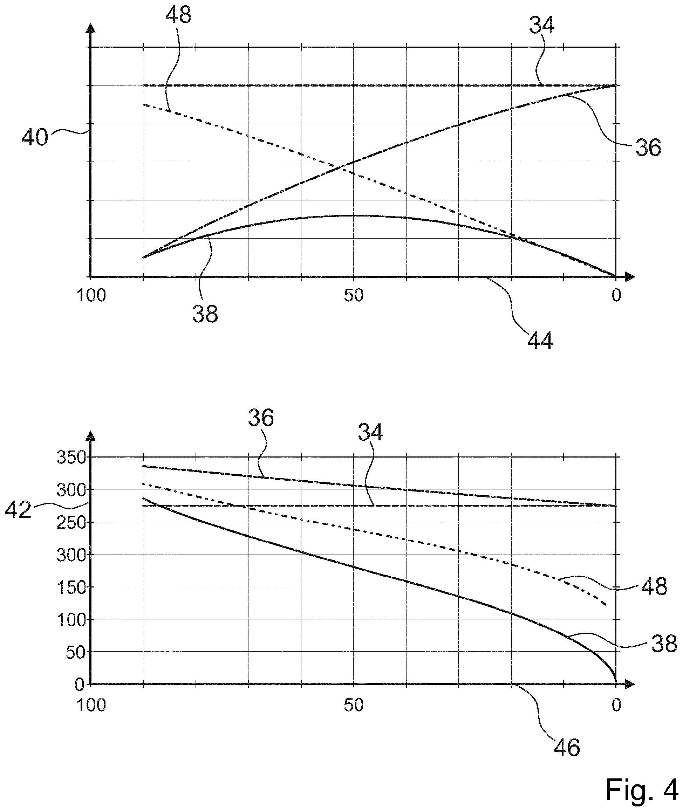

Der komplexe Korrekturwert k ist bei einer unverfälschten Übertragung der induktiven Koppeleinheit 12 gleich 1. Bei zunehmender Sättigung der induktiven Koppeleinheit 12 wird der komplexe Korrekturwert k betragsmäßig kleiner. Aufgrund der Einbrüche des Sekundärsignals 16 und der dadurch bedingten Vorverschiebung der Nulldurchgänge (vgl. Figuren 2 und 3) ändert sich ferner der Winkel des komplexen Korrekturwerts k.
Die Recheneinheit 18 ist dazu vorgesehen, den Korrekturwert k anhand eines Verhältnisses der höheren Harmonischen zu einer Grundschwingung des Sekundärsignals 16 zu ermitteln. Figur 4 zeigt in einer ersten Kurve 34 Betrag und Winkel des Primärsignals 14 ($\underline{I}_p$), in einer zweiten Kurve 36 Betrag und Winkel der Grundschwingung ($\underline{I}_{s1}$) des Sekundärsignals 16 und in einer dritten Kurve 38 Betrag und Winkel der dritten Harmonischen ($\underline{I}_{s3}$) des Sekundärsignals 16 in Abhängigkeit von einer relativen Sättigung der Koppeleinheit 12. In Figur 4 ist der Betrag an der Ordinatenachse 40 des oberen Diagramms aufgetragen, während der Winkel in Grad an der Ordinatenachse 42 des unteren Diagramms aufgetragen ist. Die relative Sättigung in Prozent ist jeweils an den Abszissenachsen 44, 46 der Diagramme aufgetragen. Es zeigt sich eine eindeutige Beziehung zwischen dem Primärsignal 14 ($\underline{I}_p$) und der Grundschwingung ($\underline{I}_{s1}$) des Sekundärsignals 16 sowie der dritten Harmonischen ($\underline{I}_{s3}$) des Sekundärsignals 16. Gemäß Figur 4 besteht bei einer Sättigung der Koppeleinheit 12 ein eindeutiger Zusammenhang zwischen der aktuellen Sättigung der Koppeleinheit 12 und einem Verhältnis von der dritten Harmonischen ($\underline{I}_{s3}$) des Sekundärsignals 16 zu der Grundschwingung ($\underline{I}_{s1}$) des Sekundärsignals 16. Die Ermittlung des Korrekturwerts k erfolgt vorteilhaft unter Verwendung des betragsmäßigen Verhältnisses von der dritten Harmonischen ($\underline{I}_{s3}$) des Sekundärsignals 16 zu der Grundschwingung ($\underline{I}_{s1}$) des Sekundärsignals 16, welches in einer vierten Kurve 48 dargestellt ist:

$$x = |\, \underline{I}_{s3} / \underline{I}_{s1} \,|$$

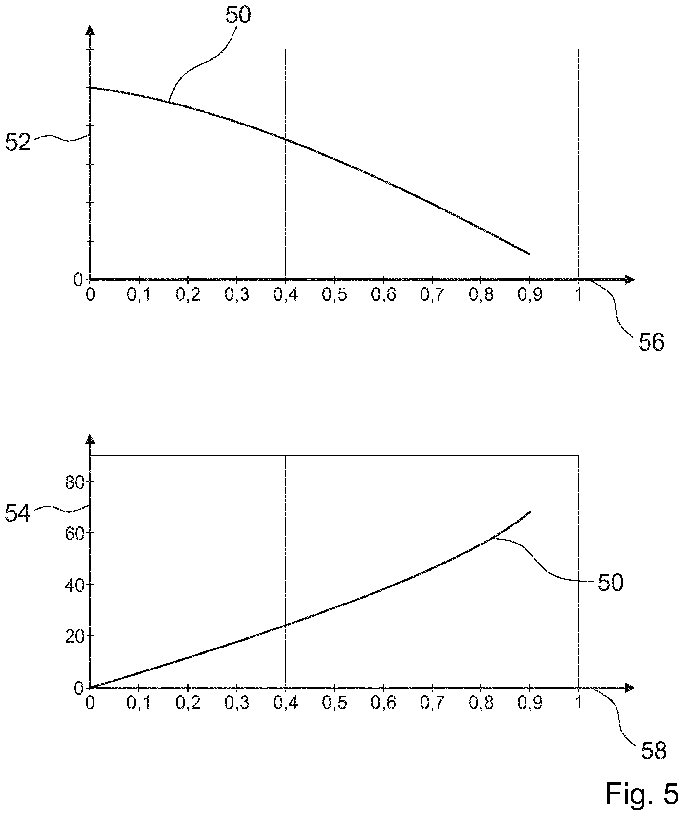

Die Abhängigkeit des Korrekturwerts k vom Verhältnis x ist eindeutig. Figur 5 zeigt in einer weiteren Kurve 50 den entsprechenden Verlauf des Korrekturwerts k in Abhängigkeit vom Verhältnis x mit Betrag und Winkel. In Figur 5 ist der Betrag an der Ordinatenachse 52 des oberen Diagramms aufgetragen, während der Winkel in Grad an der Ordinatenachse 54 des unteren Diagramms aufgetragen ist. Das Verhältnis x ist jeweils an den Abszissenachsen 56, 58 der Diagramme aufgetragen. Somit kann für sinusförmige Primärsignale 14 bei jedem Sättigungsgrad der Koppeleinheit 12 der komplexe Zeiger des Primärsignals 14 aus dem Sekundärsignal 16 hergeleitet werden:

$$\underline{I}_p = \underline{I}_s / \underline{k}$$

## Patentansprüche

1. Strommessvorrichtung zur Messung zumindest eines Wechselstroms mit zumindest einer induktiven Koppeleinheit (12), welche dazu vorgesehen ist, zumindest ein elektrisches Primärsignal (14) in zumindest ein elektrisches Sekundärsignal (16) zu wandeln, und welche zumindest eine Primärwicklung und zumindest eine Sekundärwicklung aufweist, welche auf einen gemeinsamen ferromagnetischen Kern gewickelt sind, welcher die Primärwicklung mit der Sekundärwicklung koppelt, und mit einer Recheneinheit (18), welche zu einer Bestimmung des Primärsignals (14) aus dem Sekundärsignal (16) vorgesehen ist, wobei die Recheneinheit (18) dazu vorgesehen ist, zumindest eine höhere Harmonische des Sekundärsignals (16) bei der Bestimmung des Primärsignals (14) zu berücksichtigen und anhand der höheren Harmonischen einen Korrekturwert zur Bestimmung des Primärsignals (14) aus einer Grundschwingung des Sekundärsignals zu ermitteln.

2. Strommessvorrichtung nach Anspruch 1, **dadurch gekennzeichnet, dass** die Recheneinheit (18) dazu vorgesehen ist, eine Amplitude der höheren Harmonischen zu berücksichtigen.

3. Strommessvorrichtung nach Anspruch 1 oder 2, **dadurch gekennzeichnet, dass** die Recheneinheit (18) dazu vorgesehen ist, einen Phasenwinkel der höheren Harmonischen zu berücksichtigen.

4. Strommessvorrichtung nach einem der vorhergehenden Ansprüche, **dadurch gekennzeichnet, dass** die höhere Harmonische eine ungeradzahlige höhere Harmonische des Sekundärsignals (16) ist.

5. Strommessvorrichtung nach Anspruch 4, **dadurch gekennzeichnet, dass** die höhere Harmonische die dritte Harmonische des Sekundärsignals (16) ist.

6. Strommessvorrichtung nach Anspruch 4, **dadurch gekennzeichnet, dass** die Recheneinheit (18) dazu vorgesehen ist, den Korrekturwert anhand eines Verhältnisses der höheren Harmonischen zu der Grundschwingung des Sekundärsignals (16) zu ermitteln.

7. Strommessvorrichtung nach einem der vorhergehenden Ansprüche, **dadurch gekennzeichnet, dass** das Primärsignal (14) ein sinusförmiges Wechselstromsignal ist.

8. Wechselspannungsanlage mit zumindest einer Strommessvorrichtung (10) nach einem der vorhergehenden Ansprüche.

9. Verfahren mit einer Strommessvorrichtung (10) zur Messung zumindest eines Wechselstroms, mit zumindest einer induktiven Koppeleinheit (12), welche dazu vorgesehen ist, zumindest ein elektrisches Primärsignal (14) in zumindest ein elektrisches Sekundärsignal (16) zu wandeln, und welche zumindest eine Primärwicklung und zumindest eine Sekundärwicklung aufweist, welche auf einen gemeinsamen ferromagnetischen Kern gewickelt sind, welcher die Primärwicklung mit der Sekundärwicklung koppelt, und mit einer Recheneinheit (18), welche zu einer Bestimmung des Primärsignals (14) aus dem Sekundärsignal (16) vorgesehen ist, wobei bei der Bestimmung des Primärsignals (14) zumindest eine höhere Harmonische des Sekundärsignals (16) berücksichtigt wird, wobei mittels der Recheneinheit (18) anhand der höheren Harmonischen ein Korrekturwert zur Bestimmung des Primärsignals (14) aus einer Grundschwingung des Sekundärsignals (16) ermittelt wird.

**Claims**

1. Current measuring device for measuring at least one alternating current, with at least one inductive coupling unit (12) which is configured for converting at least one electric primary signal (14) into at least one electric secondary signal (16) and which comprises at least one primary winding and at least one secondary winding wound onto a common ferromagnetic core which couples the primary winding with the secondary winding, and with a computing unit (18), which is configured for a determination of the primary signal (14) from the secondary signal (16), wherein the computing unit (18) is configured to take into account at least one higher harmonic of the secondary signal (16) when determining the primary signal (14), and to calculate a correction value for the determination of the primary signal (14) from a fundamental of the secondary signal (16) using the higher harmonic.

2. Current measuring device according to claim 1, **characterised in that** the computing unit (18) is configured to take into account an amplitude of the higher harmonic.

3. Current measuring device according to claim 1 or 2, **characterised in that** the computing unit (18) is configured to take into account a phase angle of the higher harmonic.

4. Current measuring device according to one of the preceding claims, **characterised in that** the higher harmonic is an odd-numbered higher harmonic of the secondary signal (16).

5. Current measuring device according to claim 4, **characterised in that** the higher harmonic is the third harmonic of the secondary signal (16).

6. Current measuring device according to claim 4, **characterised in that** the computing unit (18) is configured to calculate the correction value using a ratio of the higher harmonic to the fundamental of the secondary signal (16).

7. Current measuring device according to one of the preceding claims, **characterised in that** the primary signal (14) is a sinusoidal alternating-current signal.

8. Alternating current installation with at least one current measuring device (10) according to one of the preceding claims.

9. Method with a current measuring device (10) for measuring at least one alternating current, with at least one inductive coupling unit (12) which is configured for converting at least one electric primary signal (14) into at least one electric secondary signal (16) and which comprises at least one primary winding and at least one secondary winding wound onto a common ferromagnetic core which couples the primary winding with the secondary winding, and with a computing unit (18), which is configured for a determination of the primary signal (14) from the secondary signal (16), wherein at least one higher harmonic of the secondary signal (16) is taken into account when determining the primary signal (14), wherein a correction value for the determination of the primary signal (14) is calculated by the computing unit (18) from a fundamental of the secondary signal (16) using the higher harmonic.

**Revendications**

1. Dispositif de mesure de courant pour mesurer au moins un courant alternatif, avec au moins une unité inductive de couplage (12) qui est prévue à convertir au moins un signal électrique primaire (14) dans au moins un signal électrique secondaire (16) et qui comprend au moins un enroulement primaire et au moins un enroulement secondaire enroulés sur un noyau ferromagnétique commun qui couple l'enroulement primaire avec l'enroulement secondaire, et avec une unité informatique (18) qui est prévue pour une détermination du signal primaire (14) sur la base du signal secondaire (16),

où l'unité informatique (18) est prévue à considérer au moins un harmonique supérieur du signal secondaire (16) en déterminant le signal primaire (14) et à calculer, sur la base de l'harmonique supérieur, une valeur de correction pour la détermination du signal primaire (14) d'une fréquence fondamentale du signal secondaire (16).

2. Dispositif de mesure de courant selon la revendication 1,

   **caractérisé en ce que** l'unité informatique (18) est prévue à considérer une amplitude de l'harmonique supérieur.

3. Dispositif de mesure de courant selon la revendication 1 ou 2,

   **caractérisé en ce que** l'unité informatique (18) est prévue à considérer un angle de phase de l'harmonique supérieur.

4. Dispositif de mesure de courant selon l'une des revendications précédentes,

   **caractérisé en ce que** l'harmonique supérieur est un harmonique supérieur impair du signal secondaire (16).

5. Dispositif de mesure de courant selon la revendication 4,

   **caractérisé en ce que** l'harmonique supérieur est le troisième harmonique du signal secondaire (16).

6. Dispositif de mesure de courant selon la revendication 4,

   **caractérisé en ce que** l'unité informatique (18) est prévue à calculer la valeur de correction sur la base du ratio de l'harmonique supérieur et la fréquence fondamentale du signal secondaire (16).

7. Dispositif de mesure de courant selon l'une des revendications précédentes,

   **caractérisé en ce que** le signal primaire (14) est un signal de courant alternatif en forme de sinus.

8. Installation de voltage alternatif avec au moins un dispositif de mesure de courant (10) selon l'une des revendications précédentes.

9. Procédé avec un dispositif de mesure de courant (10) pour mesurer au moins un courant alternatif, avec au moins une unité inductive de couplage (12) qui est prévue à convertir au moins un signal électrique primaire (14) dans au moins un signal électrique secondaire (16) et qui comprend au moins un enroulement primaire et au moins un enroulement secondaire enroulés sur un noyau ferromagnétique commun qui couple l'enroulement primaire avec l'enroulement secondaire, et avec une unité informatique (18) prévue pour une détermination du signal primaire (14) sur la base du signal secondaire (16),

où au moins un harmonique supérieur du signal primaire (14) est considéré en déterminant le signal primaire (14),

où une valeur de correction pour la détermination du signal primaire (14) est calculée par l'unité informatique (18) sur la base d'une fréquence fondamentale du signal secondaire (16), en utilisant l'harmonique supérieur.

Fig. 1

Fig. 2

Fig. 3

Fig. 4

Fig. 5

**IN DER BESCHREIBUNG AUFGEFÜHRTE DOKUMENTE**

**In der Beschreibung aufgeführte Patentdokumente**

- JP H09145759 A